(19) Europäisches Patentamt
European Patent Office
Office européen des brevets

(11) **EP 4 700 656 A1**

(12) **EUROPEAN PATENT APPLICATION**

(43) Date of publication:
**25.02.2026 Bulletin 2026/09**

(21) Application number: **25150032.8**

(22) Date of filing: **02.01.2025**

(51) International Patent Classification (IPC):
***G06N 3/065*** *(2023.01)*

(52) Cooperative Patent Classification (CPC):
**G06N 3/065**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.08.2024 KR 20240111075**

(71) Applicant: **Pebble Square, Inc.**
**Seongnam-si, Gyeonggi-do 13488 (KR)**

(72) Inventors:
• **LEE, Choong Hyun**
**31226 Chungcheongnam-do (KR)**
• **MOON, Soung Hyun**
**03903 Seoul (KR)**

(74) Representative: **Zacco Sweden AB**
**P.O. Box 5581**
**Löjtnantsgatan 21**
**114 85 Stockholm (SE)**

(54) **NEURAL NETWORK DEVICE CONSIDERING VOLTAGE DROP AND METHOD OF IMPLEMENTING THE SAME**

(57) Provided is a neural network device including a digital-to-analog converter configured to convert a digital signal into input voltages, a cell array including a plurality of memory cells that are arranged in a plurality of bit lines and a plurality of word lines and has weights of a neural network transferred thereto, wherein the cell array is configured to output, through the plurality of bit lines, output voltages obtained by performing computation on the input voltages that are input through the plurality of word lines, and an analog-to-digital converter configured to detect the output voltages and convert the output voltages into a digital signal.

EP 4 700 656 A1

## Description

BACKGROUND

1. Field

The present disclosure relates to a neural network device considering voltage drop, and a method of implementing the same.

2. Description of the Related Art

Artificial neural networks, which mimic biological neural networks, may be trained based on a plurality of pieces of input data, and are used to estimate or approximate outcomes that are difficult to derive by using conventional techniques. An artificial neural network includes interconnected neuron layers that exchange signals, and a synapse has a weight determined based on learning or experience.

Meanwhile, an artificial neural network device, which uses an analog-to-digital converter configured to detect a current output through analog computation, has an issue that a significant voltage drop may occur due to a high output current, leading to a decrease in the accuracy of computation.

The above-mentioned background art is technical information possessed by the inventor for the derivation of the present disclosure or acquired during the derivation of the present disclosure, and cannot necessarily be said to be a known technique disclosed to the general public prior to the filing of the present disclosure.

SUMMARY

Provided are a neural network device and a method of implementing the same. The objectives of the present disclosure are not limited to the foregoing, and other technical objectives that are not mentioned herein may be clearly understood by those of skill in the art from the description of the present disclosure, and will be more clearly understood from the embodiments of the present disclosure. In addition, it would be appreciated that the objectives and advantages of the present disclosure may be implemented by means provided in the claims and a combination thereof.

Additional aspects will be set forth in part in the description which follows and, in part, will be apparent from the description, or may be learned by practice of the presented embodiments of the disclosure.

According to a first aspect of the present disclosure, a neural network device includes a digital-to-analog converter configured to convert a digital signal into input voltages, a cell array including a plurality of memory cells that are arranged in a plurality of bit lines and a plurality of word lines and has weights of a neural network transferred thereto, wherein the cell array is configured to output, through the plurality of bit lines, output voltages obtained by performing computation on the input voltages that are input through the plurality of word lines, and an analog-to-digital converter configured to detect the output voltages and convert the output voltages into a digital signal.

According to a second aspect of the present disclosure, a method of implementing a neural network device includes obtaining a computational result for input voltages by using a cell array including a plurality of memory cells to which weights of a neural network are transferred, calculating an expected value for the computational result based on the weights of the neural network, and determining a dummy conductance of each of a plurality of dummy cells that are included in the cell array but do not receive the input voltages, based on a difference between the computational result and the expected value, wherein each of a plurality of bit lines of the cell array is connected to an analog-to-digital converter configured to detect output voltages corresponding to the input voltages, and convert the output voltages into a digital signal.

According to a third aspect of the present disclosure, a computer-readable recording medium may have recorded thereon a program for causing a computer to execute the method according to the second aspect.

In addition, other methods and devices for implementing the present disclosure, and a computer-readable recording medium having recorded thereon a program for executing the method may be further provided.

Other aspects, features, and advantages other than those described above will be apparent from the following drawings, claims, and detailed description.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a diagram for describing an implementation of a neural network system according to an embodiment;

FIGS. 2 and 3 are exemplary diagrams for comparing a Von Neumann architecture with a computing-in-memory (CIM) architecture, according to an embodiment of the present disclosure;

FIG. 4 is a diagram illustrating a neural network device according to an embodiment of the present disclosure;

FIGS. 5A and 5B are drawings for describing an operating method of a neural network system according to an embodiment;

FIGS. 6A and 6B are diagrams for comparing vector-matrix multiplication with operations performed in a cell array, according to an embodiment;

FIG. 7 is a diagram for describing an example in which an operation is performed in a cell array, according to an embodiment;

FIG. 8 and FIG. 9 are drawings for describing an operation method of a neural network device according to an embodiment of the present disclosure;

FIG. 10 is a diagram illustrating an implementation example of a neural network device according to an embodiment of the present disclosure;

FIG. 11 is a diagram illustrating an implementation example of a neural network device according to another embodiment of the present disclosure;

FIG. 12 is a diagram illustrating an implementation example of a neural network device according to another embodiment of the present disclosure;

FIG. 13 is a flowchart of a method of implementing a neural network device, according to an embodiment of the present disclosure; and

FIG. 14 is a block diagram of a device for implementing a neural network device, according to another embodiment of the present disclosure.

## DETAILED DESCRIPTION

In describing the present disclosure, detailed explanations of the related art are omitted when it is deemed that they may unnecessarily obscure the gist of the present disclosure, and unless otherwise defined, all terms used herein have the same meaning as commonly understood by one of skill in the art to which the present disclosure pertains.

As used herein, phrases such as "according to an embodiment", "regarding an embodiment, or "according to an implementation of an embodiment" does not necessarily indicate the same embodiment.

As the present embodiments allows for various changes and numerous forms, some embodiments will be illustrated in the drawings and described in detail. However, this is not intended to limit the present embodiments to particular modes of practice, and it is to be appreciated that all changes, equivalents, and substitutes that do not depart from the spirit and technical scope of the present embodiments are encompassed in the present disclosure. Terms used herein are merely used to describe embodiments, and are not intended to limit the embodiments.

Although the terms used for describing embodiments are selected from among common terms that are currently widely used in consideration of functions in the embodiments, the terms may vary according to an intention of one of ordinary skill in the art to which the embodiments pertain, a precedent, or the advent of new technology. In addition, in certain cases, there are also terms arbitrarily selected by the applicant, and in this case, the meaning thereof will be defined in detail in the description. Therefore, the terms used in describing the present embodiments are not merely designations of the terms, but the terms are defined based on the meaning of the terms and content throughout the present embodiments.

Some embodiments of the present disclosure may be represented by functional block components and various processing operations. Some or all of the functional blocks may be implemented by any number of hardware and/or software elements that perform particular functions. For example, the functional blocks of the present disclosure may be embodied by at least one microprocessor or by circuit components for a certain function.

In addition, for example, the functional blocks of the present disclosure may be implemented by using various programming or scripting languages. The functional blocks may be implemented by using various algorithms executable by one or more processors. In addition, the present disclosure may employ known technologies for electronic settings, signal processing, and/or data processing.

Terms such as "database", "element", "unit", or "component" are used in a broad sense and are not limited to mechanical or physical components. In addition, as used herein, the terms such as "...er (or)", "...unit", "... module", etc., denote a unit that performs at least one function or operation, which may be implemented as hardware or software or a combination thereof.

In addition, connection lines or connection members between components illustrated in the drawings are merely exemplary of functional connections and/or physical or circuit connections. Various alternative or additional functional connections, physical connections, or circuit connections between components may be present in a practical device.

In addition, although the terms such as 'first' or 'second' may be used herein to describe various elements, these elements should not be limited by these terms. The terms are used only to distinguish one element from other elements.

In addition, the size or thickness of some elements in the drawings may be exaggerated. In addition, elements illustrated in one drawing may not be illustrated in another drawing.

Throughout the present specification, the term embodiment' is an arbitrary distinction used to facilitate description of the present disclosure, and the embodiments are not necessarily mutually exclusive. For example, configurations disclosed in an embodiment may be applied and/or implemented in other embodiments, and may be applied and/or implemented with modifications without departing from the scope of the present disclosure.

In addition, terms used herein are for the purpose of describing embodiments, and are not intended to limit the embodiments. The singular expression used herein also includes the plural meaning unless mentioned otherwise.

Hereinafter, embodiments of the disclosure will be described in detail with reference to the accompanying drawings to allow those of skill in the art to easily carry out the embodiments. However, the embodiments of the present disclosure may be embodied in various different forms, and the present disclosure is not limited to the embodiments described herein.

Hereinafter, the present disclosure will be described in detail with reference to the drawings based on the above description.

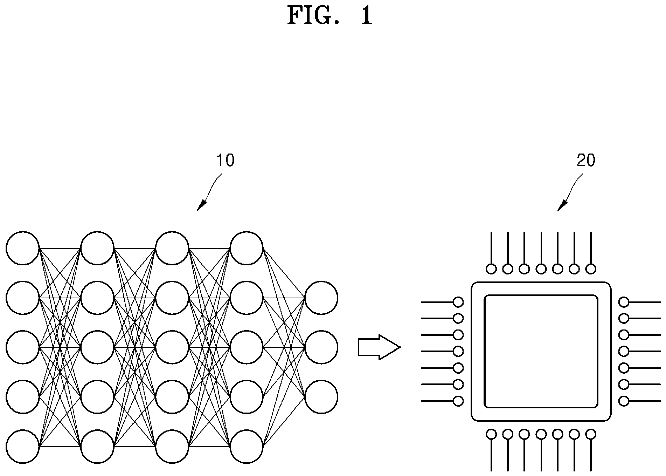

FIG. 1 is a diagram for describing an implementation of a neural network system according to an embodiment.

FIG. 1 illustrates a trained neural network 10, and a device 20 in which the neural network 10 is implemented.

That the neural network 10 has been trained means that weights of each layer of the neural network 10 have been determined by using a large amount of training data. In a case in which the weights, which are a result of training the neural network 10, are stored in a central cloud server, a cloud computing device using the neural network 10 may communicate with the central cloud server to transmit an input value to the neural network 10 and receive an output value. In this case, even when the neural network 10 is significantly complex or large-scale, the output value may be used by the cloud computing device without any problem.

However, in a case in which the device 20 is an edge computing device configured to process data on the device itself without communicating with a central cloud server, the weights of the neural network 10 determined through training are stored in the device 20, which is physical hardware, and specifically, are stored in memory cells that constitute a cell array of the device 20. In this case, the device 20 may be a neuromorphic chip.

Neuromorphic chips are hardware that mimic functions of the human brain, with circuits generated to mimic neurons. In other words, neuromorphic chips are computer chips that mimic the structure of the nervous system. Neuromorphic chips are composed solely of circuits necessary for neural network operations, allowing for gains of over several hundred times in terms of power, area, and speed. Neuromorphic chips mimic the functioning of the brain, with structures arranged in parallel to connect neurons and synapses, and the structures are connected and disconnected when data processing is not performed, enabling energy savings. For example, the von Neumann architecture, which is a traditional computer, excels at executing precisely written programs because it processes data sequentially when input, however, it has issues with efficiency in areas such as power consumption limits, pattern recognition, or real-time recognition. On the other hand, neuromorphic chips use analog operations where data gradually changes through various states, rather than digital states like 0 and 1. That is, artificial neurons arranged in parallel operate in an event-driven manner without clock operations. Thus, they may efficiently process unstructured characters, voice, images, and the like, which are difficult for conventional computers to recognize intuitively.

In an embodiment, when input data such as an image, a voice, or an electromagnetic wave is input into a neuromorphic chip, certain output data may be output through an operation performed on the input data inside the neuromorphic chip. Here, the data input into the neuromorphic chip is not limited to images, voices or electromagnetic waves as described above, and may include various types of data such as video or text.

A neuromorphic device according to an embodiment may be implemented as an edge artificial intelligence (AI) chip. Edge AI refers to the technology that enables of execution of AI algorithms on hardware devices by using edge computing that is based on data generated by a system. AI processing is mainly performed in cloud-based data centers that require massive computing capacity, leading to a high dependence on servers. On the contrary, using edge AI enables AI algorithm computation to be performed locally, reducing reliance on the cloud (servers), lowering associated communication costs, and protecting privacy by preventing sensitive personal information from being transmitted to the cloud. Thus, by configuring a neuromorphic device as an edge AI chip, it is possible to achieve not only cost reduction and enhanced security but also immediate processing of computations inside the same hardware, and thus, a highly responsive system may be implemented.

Meanwhile, in the neural network 10, the state of each weight may be significantly diverse (e.g., 128 states), and a memory cell of a cell array implemented in the device 20 may be implemented as a multi-bit (e.g., 8-bit) memory cell to store the state of the weight. Meanwhile, in manufacturing the device 20, various methods have been proposed to reduce the chip area and increase the accuracy and speed of computation.

In the following description, the device 20 according to an embodiment of the present disclosure, that is, a neural network device, may be the neuromorphic device described above. In other words, the neuromorphic device described above may function as the neural network device according to an embodiment of the present disclosure.

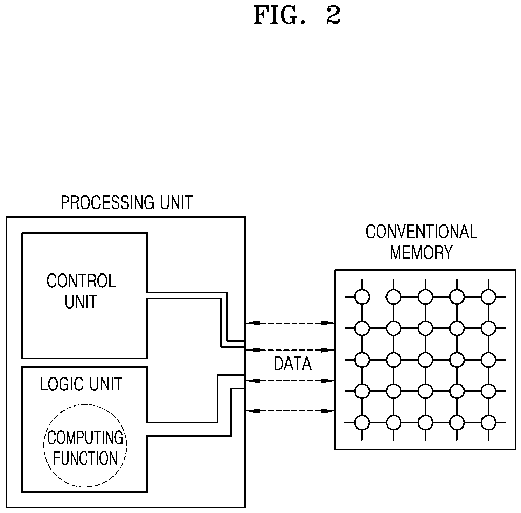

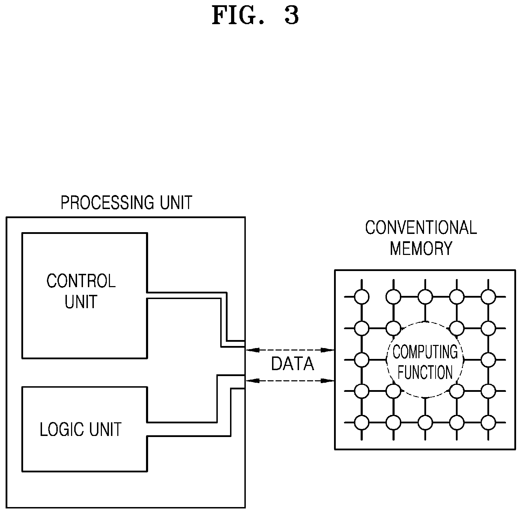

FIGS. 2 and 3 are exemplary diagrams for comparing a Von Neumann architecture with a computing-in-memory (CIM) architecture, according to an embodiment of the present disclosure.

Referring to FIG. 2, the von Neumann architecture is a computer architecture proposed by John von Neumann, and is a stored-program computer architecture configured in a typical three-stage structure of a main memory device, a central processing unit, and an input/output device.

The von Neumann architecture has the advantage of greatly enhancing versatility, as it allows for changes to be made to software (a program) without needing to rearrange hardware (wires, etc.) when switching to other tasks, however, it executes a sequence of listed instructions sequentially, and those instructions consist of tasks that modify values at particular memory locations, which may lead to serious issues in the design of highspeed computers. This is referred to as von-Neumann bottleneck.

To solve the von Neumann bottleneck, alternatives have been suggested, such as the Harvard architecture, which divides a memory into where instructions are stored and where data is stored, the CIM architecture with a memory that performs data operations as well as data storage, and neuromorphic computing for configuring countless units with integrated computation and memory functions in the form of an artificial neural network that mimics the brain structure of higher animals, connecting them in parallel like a network, and then operating each unit in an event-driven manner.

Referring to FIG. 3, it may be seen that a CIM structure includes a processor and a memory having a computing function.

Unlike the conventional von Neumann architecture where all data in a memory is transferred to a processor for computation, the CIM architecture performs computation in the memory when a command of the processor is transmitted, and transfers only resulting data to the processor such that there is no transfer of large amounts of data, thereby effectively resolving the von Neumann bottleneck described above. In addition, it has the advantage of significantly reduced power consumption.

A neural network device according to an embodiment of the present disclosure may perform computation by using only an on-chip memory without using an external memory. For example, the neural network may perform computation for each layer based on CIM by using only the on-chip memory without using an external memory (e.g., an off-chip memory), thereby performing computation without memory updates while processing input signals. In detail, the neural network device may perform CIM-based computation in which each memory cell and a processor are directly connected to each other.

However, CIM-based AI chips perform computation directly within an internal memory without exchanging data with an external memory, eliminating bottlenecks caused by data transfer between a traditional memory and a computation device. Accordingly, CIM-based AI chips may fundamentally resolve a memory bandwidth issue. In addition, this structure offers the advantage of reducing power consumption and minimizing heat generation.

A cell array of a neural network device according to an embodiment of the present disclosure may be configured as a memory capable of implementing a multi-bit configuration for maximizing computation of such a CIM structure. For example, the neural network device may be configured with a memory capable of implementing 7 bits (128 analog memory states). By configuring a large-scale neural network, it is possible to process a large amount of data with low power consumption and high performance even for long periods of use, unlike general CIM chips that have issues such as overheating or performance degradation.

Meanwhile, the on-chip memory may be implemented by cell arrays. That is, the cell array may receive a command from the processor and perform computation, and memory cells of the cell array are integrated in the on-chip memory to achieve CIM computation. For example, the processor may receive an input signal, and obtain an output signal by operating a neural network device trained based on certain training data.

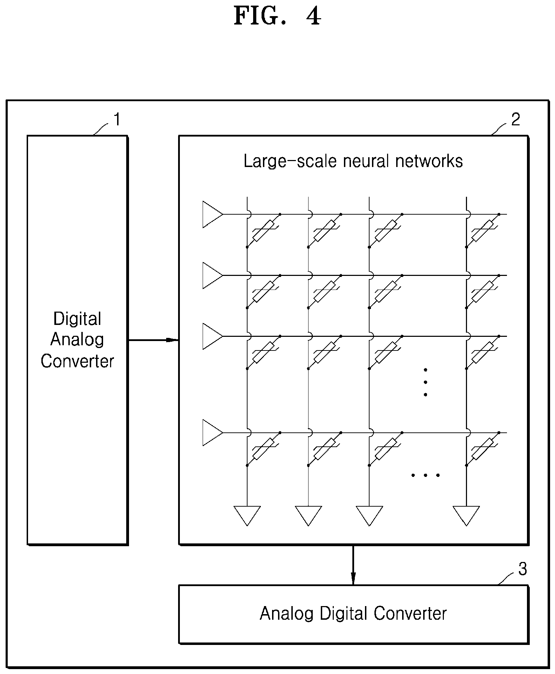

FIG. 4 is a diagram illustrating a neural network device according to an embodiment of the present disclosure.

The neural network device may be implemented with various types of devices, such as personal computers (PCs), server devices, mobile devices, or embedded devices, and may correspond to, as specific examples, smart phones, tablet devices, augmented reality (AR) devices, Internet-of-Things (IoT) devices, autonomous vehicles, robotics, medical devices, and the like for performing speech recognition, image recognition, image classification by using an artificial neural network, but is not limited thereto. Furthermore, the neural network device may correspond to a dedicated hardware accelerator (HW accelerator) mounted on any one of the above devices, and may be a hardware accelerator such as a neural processing unit (NPU), a tensor processing unit (TPU), or a neural engine, which is a dedicated module for operating a neural network, but is not limited thereto.

The neural network device may include a digital-to-analog converter 1, a cell array 2, and an analog-to-digital converter 3. FIG. 4 illustrates only components of the neural network device that are related to the present embodiments, and it will be apparent to those skilled in the art that the neural network device may further include other general-purpose components in addition to the components illustrated in FIG. 4.

The neural network device according to an embodiment may include the digital-to-analog converter 1.

The digital-to-analog converter 1 according to an embodiment may convert an input signal having a digital value into an input voltage, which is an analog signal. That is, the digital-to-analog converter 1 may convert a digital signal into an input voltage. For example, the digital-to-analog converter 1 may receive a multi-bit digital signal, convert it into an input voltage corresponding to the number of bit lines, and apply the input voltage to a plurality of bit lines.

The neural network device according to an embodiment may include the cell array 2 including a plurality of memory cells arranged in a plurality of bit lines and a plurality of word lines.

The plurality of word lines of the cell array 2 according to an embodiment may be connected to the digital-to-analog converter 1 to receive, from the digital-to-analog converter 1, an input voltage that is an analog signal converted from a digital signal.

As described above, the plurality of memory cells may store weights of a neural network. That is, the weights of the neural network may be transferred to the plurality of memory cells. For example, when an input voltage is input through each of the plurality of word lines of the cell array 2, a multiply-and-accumulate (MAC) operation between the input voltage and the weights of the neural network transferred to the plurality of memory cells is performed such that an analog output may be output through each of the plurality of bit lines. Here, the analog output according to an embodiment may be an output voltage. In other words, the cell array 2 may perform an operation on an input voltage that is input through a word line, and output a resulting output voltage through a bit line.

The neural network device according to an embodiment may include the analog-to-digital converter 3.

The analog-to-digital converter 3 according to an embodiment may be connected to the plurality of bit lines of the cell array 2, and may convert analog signals output by the plurality of bit lines into digital signals. For example, the analog signal is an output voltage, and the analog-to-digital converter 3 may detect the output voltage and convert it into a digital signal. In addition, for example, the analog-to-digital converter 3 may receive output voltages output from the plurality of bit lines, and convert them into digital outputs having a certain number of bits.

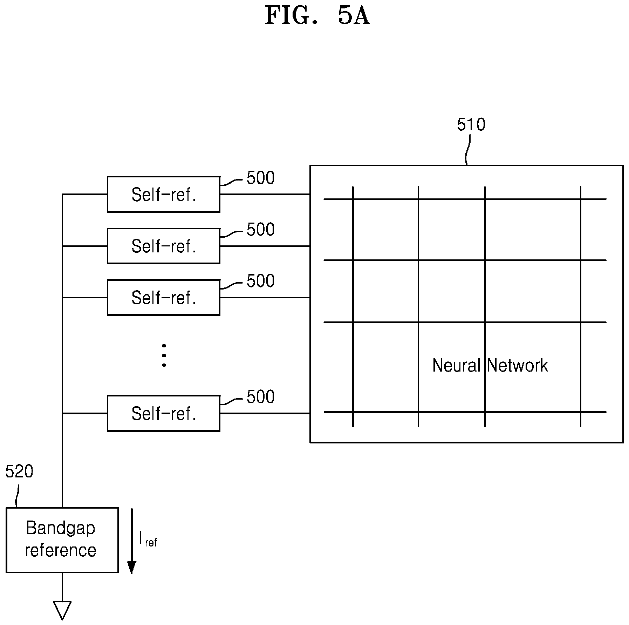

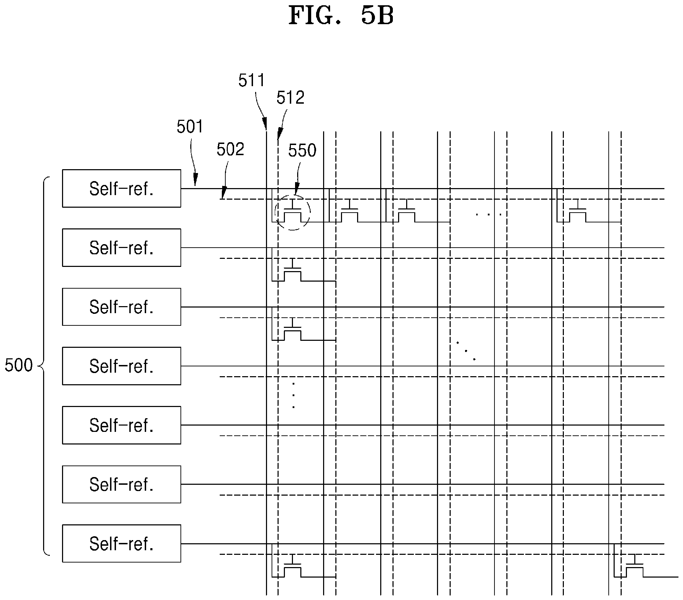

FIGS. 5A and 5B are diagrams for describing an operation method of a neural network system according to an embodiment.

FIG. 5A is a diagram illustrating an example of a neural network system implemented by using self-referential programming.

The neural network system may include self-referential circuits 500, a neural network circuit 510, and a bandgap circuit 520.

The neural network circuit 510 may include a plurality of memory cells arranged in an array. Hereinafter, the memory cells included in the neural network circuit 510 are referred to as first memory cells. The first memory cells may correspond to not only flash memory, but also resistive random-access memory (RRAM), phase-change random-access memory (PRAM), magnetoresistive random-access memory (MRAM), and the like.

The bandgap circuit 520 may provide a reference voltage such that constant voltages are applied to the self-referential circuits 500. The bandgap circuit 520 may operate as a reference voltage source or a reference current source because its output does not change sensitively depending on an external environment, and is thus also referred to as a bandgap reference circuit. The bandgap circuit 520 may be electrically connected to a plurality of self-referential circuits 500 to provide a reference voltage or a reference current such that constant voltages or constant currents are applied to the self-referential circuits 500.

In an embodiment, the self-referential circuits 500 may be electrically connected to row lines of the neural network circuit 510. In a case in which the neural network circuit 510 forms a crossbar array with M row lines and N column lines, M self-referential circuits 500 may be electrically connected to the row lines of the neural network circuit 510, respectively. The self-referential circuit 500 may perform weight programming for the first memory cell located on the row line connected thereto. Hereinafter, all memory cells located on the row lines to which the self-referential circuits 500 are connected, from among the first memory cells are defined as target memory cells.

In an embodiment, the self-referential circuits 500 may apply currents to the row lines connected thereto, such that a plurality of target memory cells have preset target weights. For example, the neural network system may further include a write circuit (not shown) configured to perform a programming operation on a target memory cell such that the target memory cell has a preset target weight. That is, the self-referential circuit 500 may perform a read operation on the target memory cell, specifically, may deliver an accurate source voltage to the target memory cell, and the write circuit (not shown) may perform a write operation on the target memory cell.

FIG. 5B illustrates a crossbar array circuit embodying the neural network circuit 510 of FIG. 5A, and the self-referential circuits 500 may be confirmed.

The neural network circuit 510 may include a first crossbar array and a second crossbar array. The memory cells of the neural network circuit 510 may be configured as split-gate memory cells to implement a two-layer crossbar array structure. For convenience of description, the first row line (hereinafter, referred to as "first row line") 501 and the first column line (hereinafter, referred to as "first column line") 511 of the first crossbar array, and the first row line (hereinafter, referred to as "first* row line") 502 and the first column line (hereinafter, referred to as "first* column line") 512 of the second crossbar array will be described.

The first row line 501 may correspond to a source line that supplies a source voltage to a memory cell 550. The first column line 511 may correspond to a bit line that performs a read operation. The first* row line 502 may supply an input voltage to the memory cell 550. The first* column line 512 may correspond to a word line that performs a write operation.

A target memory cell 550 located on the first row line 501 and the first column line 511 of the neural network circuit 510 may have its components electrically connected to the first column line 511, the first* row line 502, and the first* column line 512.

In detail, a drain region of the target memory cell 550 may be connected to the first column line 511 to receive a drain voltage from the first column line 511. A control gate of the target memory cell 550 may be connected to the first* row line 502 to receive a gate voltage from the first* row line 502. Thus, the first* row line 502 may perform a write operation on the target memory cell 550. A select gate of the target memory cell 550 may be connected to the first* column line 512. A source region of the target memory cell 550 may be electrically connected to the self-referential circuit 500.

In an embodiment, for the self-referential circuit 500 connected to the first row line 501, a cell selection circuit (not shown) may select a designated memory cell by designating a particular column line, that is, a target line. The intersection of the row line and the column line that are connected to the first memory cell is determined as the address of the first memory cell, and each first memory cell has a preset target weight. Thus, the cell selection circuit (not shown) may select a designated memory cell such that a current corresponding to the target weight may be applied to the appropriate memory cell from the self-referential circuit 500.

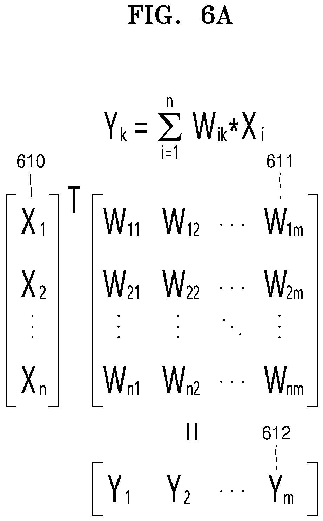

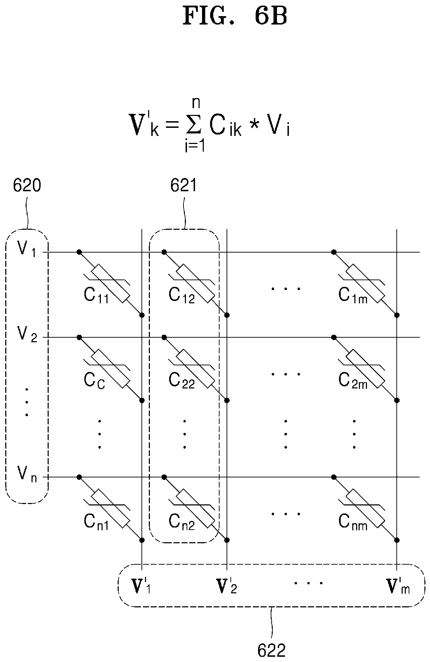

FIGS. 6A and 6B are diagrams for comparing vector-matrix multiplication with operations performed in a cell array, according to an embodiment.

First, referring to FIG. 6A, a convolution operation between input data and a kernel may be performed by using vector-matrix multiplication. For example, the input data may be represented by a matrix X 610, and weight values may be represented by a matrix W 611 as a kernel. Output data may be represented by a matrix Y 612, which is a result of a multiplication operation between the matrix X 610 and the matrix W 611. In an embodiment, the matrix W 611 may include the conductance of each of a plurality of memory cells, as an element.

Referring to FIG. 6B, a vector multiplication operation may be performed by using a plurality of memory cells of a cell array. Comparing with FIG. 6A, input data may be received as input values of the memory cells, and the input values may be voltages 620. In addition, the weight values may be stored in synapses of a core, that is, the memory cells, and the weight values stored in the memory cells may be conductances 621. Thus, output values of the memory cells may be expressed as voltages 622, which are results of dividing the sums of the products of the voltages 620 and the conductances 621, by the sum of the conductances 621, respectively.

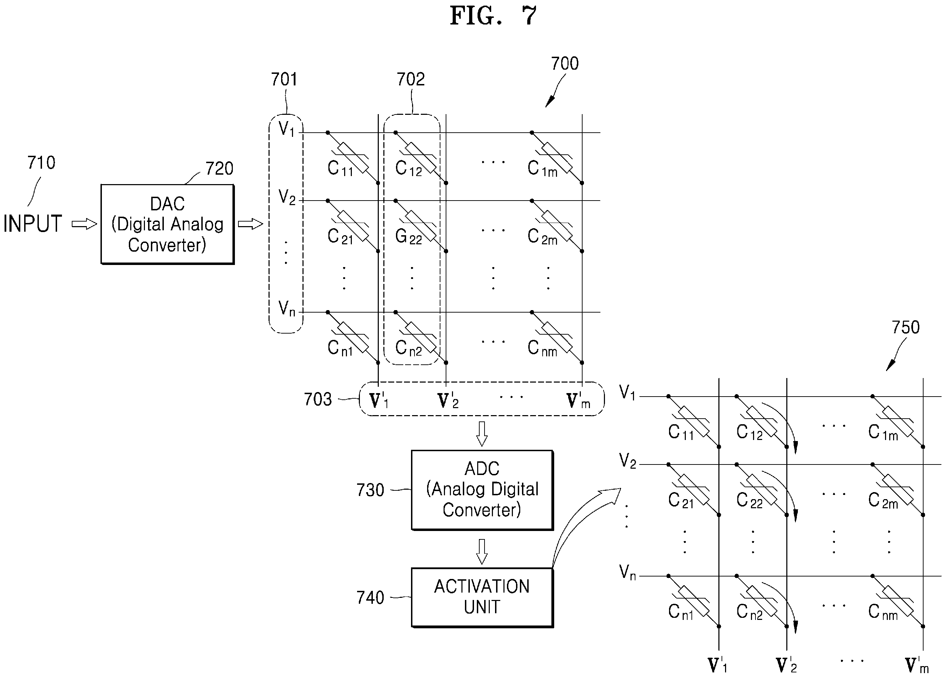

FIG. 7 is a diagram for describing an example in which an operation is performed in a cell array, according to an embodiment.

In an embodiment, a neural network device may receive an input signal 710. Here, the input signal 710 may be a digital input having a digital value. The input signal 710 may be converted into an analog input 701 via a digital-to-analog inverter 720. In addition, the converted analog input 701 may be input to a plurality of word lines of a core 700 implemented as at least a portion of the cell array.

In addition, in the core 700, trained kernel values may be stored in a plurality of memory cells. For example, the kernel values stored in the plurality of memory cells may be conductances 702. Here, the cell array may produce output values by performing a vector multiplication operation between the analog input 701 and the conductances 702, and the output values may be expressed as an analog output 703 (e.g., voltage values).

Because the analog output 703 (e.g., voltages) output from the core 700 is an analog signal, the analog output 703 may be converted into a digital input through an analog-to-digital converter 730, so as to be used as input data for another core 750 of the cell array. The cell array may convert the analog output 703 into a digital signal by using the analog-to-digital converter 730.

The neural network device may apply an activation function to a digital signal converted by the analog-to-digital converter 730, by using an activation unit 740. A sigmoid function, a tanh function, and a rectified linear unit (ReLU) function may be used as activation functions, but activation functions that may be applied to digital signals are not limited thereto. The digital signal to which the activation function is applied may be used as an input value for the other core 750. When a digital signal to which an activation function is applied is used as an input value for the other core 750, the above-described processes may be applied identically to the other core 750.

In addition, the core 700 and the other core 750 may not be physically separated from each other, but the weight values of the memory cells included in the cell array may be changed according to the weight and/or bias values of each core 700 and 750.

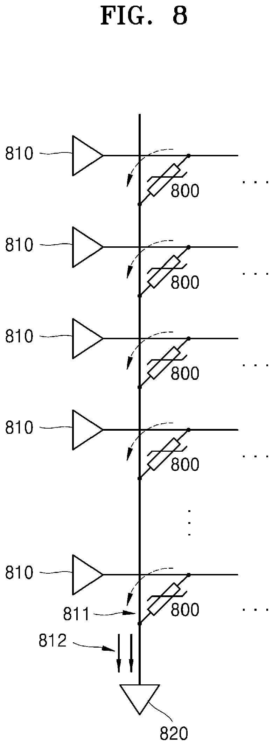

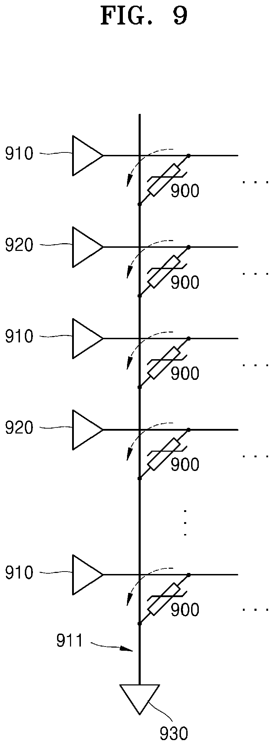

FIG. 8 and FIG. 9 are drawings for describing an operation method of a neural network device according to an embodiment of the present disclosure.

FIG. 8 is a diagram illustrating an embodiment in which an arbitrary bit line 811 outputs an output current 820. In addition, FIG. 8 illustrates a plurality of memory cells 800 connected to the arbitrary bit line 811. That is, a plurality of bit lines 811 of a cell array may be connected to a current-sensing analog-to-digital converter configured to detect a current and converts it into a digital signal.

In an embodiment, input voltages 810 converted through a digital-to-analog converter may be input to the plurality of memory cells 800. In addition, the arbitrary bit line 811 may output the output current 820 as a result of an operation between the input voltages 810 and the plurality of memory cells 800.

Here, currents passing through the respective memory cells 800 may be accumulated in the bit line 811 to form a high output current 812. In addition, there is an issue that a large voltage drop (IR drop) occurs in the bit line 811 itself due to the high output current 812, making it difficult to ensure the accuracy of the current-sensing analog-to-digital converter.

FIG. 9 is a diagram illustrating an embodiment in which an arbitrary bit line 911 outputs an output voltage 930. In addition, FIG. 9 illustrates a plurality of memory cells 900 connected to the arbitrary bit line 911. That is, a plurality of bit lines 911 of a cell array may be connected to a voltage-sensing analog-to-digital converter configured to detect a voltage and converts it into a digital signal.

In an embodiment, input voltages 910 and 920 converted through a digital-to-analog converter may be input to the plurality of memory cells 900. In addition, the arbitrary bit line 911 may output the output voltage 930 as a result of an operation between the input voltages 910 and 920 and the plurality of memory cells 900.

In an embodiment, the high voltage 910 and the low voltage 920 may be input to a plurality of word lines. A reference voltage for distinguishing between the high voltage 910 and the low voltage 920 may be preset and may be changed depending on an operation result of the neural network device, etc.

For example, when digital signals are converted into the input voltages 910 and 920 through an 8-bit digital-to-analog converter, the input voltages 910 and 920 may each be any one of voltage values divided from 0 to 2.5V in intervals of approximately 9 mV. Here, a voltage of 0 V or greater but less than 1.25 V that is the median may be a relatively low voltage 920, and a voltage from 1.25 V to 2.5 V may be a relatively high voltage 910. Referring to FIG. 9, the high voltage 910 may be input to the memory cells 900 located on the odd-numbered (first, third, fifth, ...) word lines, and the low voltage 920 may be input to the memory cells 900 located on the even-numbered (second, fourth, sixth, ...) word lines. The high voltage 910 and the low voltage 920 may be alternately input to the memory cells 900 on the plurality of word lines. A current flows from the memory cell 900 to which the high voltage 910 is input, to the memory cell 900 to which the low voltage 920 is input, on the plurality of word lines.

As a result, in the odd-numbered memory cells 900, a current flows from the upper word line to the lower word line, and in the even-numbered memory cells 900, a current flows from the lower word line to the upper word line, such that the currents may compensate for each other.

Accordingly, the issue of a high output current being formed in the bit line 911 may be solved because currents passing through the respective memory cells 900 are not accumulated in the bit line 911. In addition, the output voltage 930 of the bit line 911 is the equilibrium voltage of the bit line 911.

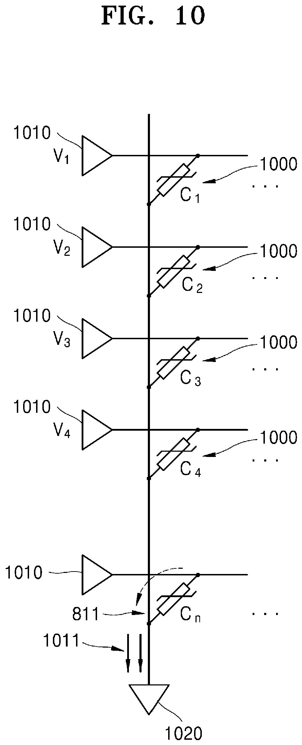

FIG. 10 is a diagram illustrating an implementation example of a neural network device according to an embodiment of the present disclosure.

FIG. 10 illustrates input voltages 1010 that are input to a plurality of word lines, an output voltage 1020 that is output from an arbitrary bit line 1011, and a plurality of memory cells 1000 connected to a plurality of word lines and the arbitrary bit line 1011. Assuming that the number of word lines is n (n is an integer greater than or equal to 2), for convenience of description, the input voltage 1010 input to the i-th word line from the top will be referred to as $V_n$, and the conductance of the memory cell 1000 connected to the i-th word line and the arbitrary bit line 1011 will be referred to as $C_n$.

In an embodiment, the output voltage 1020 of the bit line 1011 may be a weighted average of input voltages 1010 that are input through the plurality of word lines. Here, the weight of the weighted average may be the conductance of the memory cell 1000 connected to the bit line 1011 and corresponding to the input voltage 1010. That is, the output voltage 1020 $V_{out}$ of the arbitrary bit line 1011 may be a weighted average with a conductance $C_i$ as the weight for the input voltage 1010 $V_i$. For example, the output voltage 1020 $V_{out}$ of the arbitrary bit line 1011 is as in Equation 1 below.

【Equation 1】

$$V_{out} = \frac{\Sigma_i V_i \cdot C_i}{\Sigma_i C_i}$$

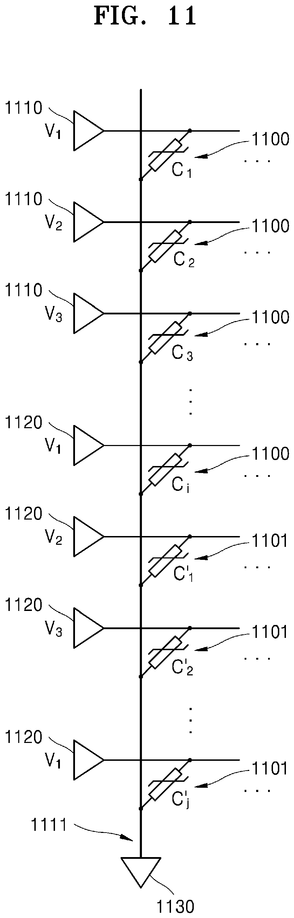

FIG. 11 is a diagram illustrating an implementation example of a neural network device according to another embodiment of the present disclosure.

FIG. 11 illustrates input voltages 1110 and 1120 that are input to a plurality of word lines, an output voltage 1130 that is output from an arbitrary bit line 1111, a plurality of memory cells 1100 connected to a plurality of word lines and the arbitrary bit line 1111, and dummy cells 1101. Assuming that the number of word lines is i (i is an integer greater than or equal to 2), for convenience of description, the input voltage 1110 input to the i-th word line from the top will be referred to as $V_i$, the conductance of the memory cell 1100 connected to the i-th word line and the arbitrary bit line 1111 will be referred to as $C_i$, and the conductance of the dummy cell 1101 connected to the (i+j)-th word line and the arbitrary bit line 1111 will be referred to as $C'_i$. In addition, hereinafter, the conductances of the memory cells 1100 will be referred to as effective conductances, and the conductances of the dummy cells 1101 will be referred to as dummy conductances.

In an embodiment, a plurality of dummy cells 1101 may be included in a cell array and connected to each of a plurality of bit lines 1111. However, here, the same number of dummy cells 1101 may be connected to each of the plurality of bit lines 1111. In FIG. 11, the number of dummy cells 1101 connected to each of the plurality of bit lines 1111 is j.

In an embodiment, at least some of the plurality of word lines may be connected to a plurality of dummy cells 1101. However, the word line connected to the dummy cells 1101 may not apply the input voltages 1120 to the dummy cells 1101. Alternatively, the dummy cells 1101 may receive the input voltages 1120 of 0 V from the word line. That is, hereinafter, the input voltages 1120 that are input to the dummy cells 1101 may mean 0 V.

In an embodiment, the dummy conductances of the dummy cells 1101 may be determined based on differences between results of operations performed on the input voltages 1110 of the memory cells 1100 based on the effective conductances, and expected values based on the weights of the neural network. That is, as described above with reference to FIG. 1, the weights of the neural network may be transferred to the plurality of memory cells 1100 of the neural network device, but the weights of the neural network may not be accurately transferred to the plurality of memory cells 1100 due to issues such as volatility, deterioration, and noise of the memory cells 1100, and parasitic resistance occurring in the interconnects of the cell array. Otherwise, even when the transfer is accurately performed, computational results on the device may differ from expected values mechanically computed with the weights of the neural network. Here, the dummy cells 1101 may be added to the cell array to compensate for the differences between the actual computational result values and the expected values.

In an embodiment, the output voltage 1130 of the bit line 1111 may be determined based on the input voltages 1110 and 1120 that are input through the plurality of word lines, the effective conductances of the plurality of memory cells 1100 connected to the bit line 1111, and the dummy conductances of the plurality of dummy cells 1101 connected to the bit line 1111. In detail, the output voltage 1130 of the bit line 1111 may be a weighted average of the input voltages 1110 and 1120 that are input through the plurality of word lines.

Here, the weight of the weighted average may be the conductance of the memory cell 1100 connected to the bit line 1111 and corresponding to the input voltage 1110. That is, the output voltage 1120 $V_{out}$ of the arbitrary bit line 1111 may be a weighted average with a conductance $C_i$ as the weight for the input voltage 1110 $V_i$. In addition, the output voltage 1130 $V_{out}$ of the arbitrary bit line 1111 may be a value obtained by dividing a weighted sum of the input voltages 1110 $V_i$ with the effective conductances $C_i$ as weights for all memory cells 1100 connected to the bit line 1111, by the sum of the effective conductances $C_i$ of all memory cells 1100 connected to the bit line 1111, and the dummy conductances $C'_i$ of all dummy cells 1101 connected to the bit line 1111. For example, the output voltage 1130 $V_{out}$ of the arbitrary bit line 1111 is as in Equation 2 below.

【Equation 2】

$$V_{out} = \frac{\sum_i V_i * C_i}{\sum_i C_i + \sum_{ij} C'_j}$$

For example, the output voltage 1130 generated through the bit line 1111 may be the result of an operation on the input voltages based on the effective conductances of the memory cells 1100. If non-zero dummy conductances are set in the plurality of dummy cells 1101 connected to the bit line 1111, both the effective conductances and the dummy conductances may affect the output voltage 1130.

The expected value represents the theoretical value that the result of the operation between the input voltages 1110 and the memory cells 1100 should have.

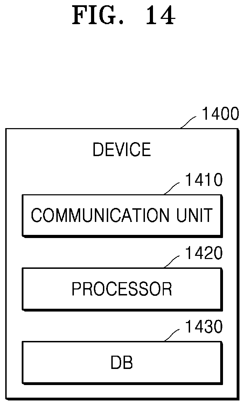

The expected value may be calculated as in the right-hand side of Equation 2 described above, and may be computed by a computing device such as the "device for implementing a neural network device" described later with reference to FIG. 14, using information about the weights stored in the memory cells 1100. If non-zero dummy conductances are set in the plurality of dummy cells 1101 connected to the bit line 1111, the device for implementing the neural network device may calculate the expected value using information about the weights stored in the memory cells 1100 and the weights stored in the dummy cells 1101.

In an ideal situation, the measured result of the operation may be identical to the calculated expected value. However, if there is a difference between the result of the operation and the expected value, the device for implementing the neural network device may determine the dummy conductances to be stored in the dummy cells 1101 so that the result of the operation approaches the expected value.

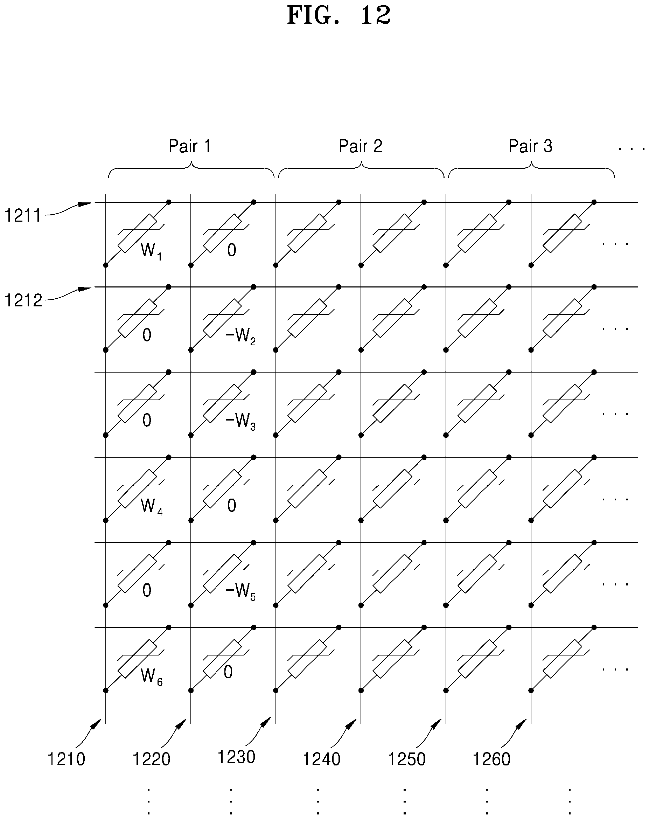

FIG. 12 is a diagram illustrating an implementation example of a neural network device according to another embodiment of the present disclosure.

In an embodiment, a plurality of bit lines 1210 to 1260 may include first bit lines 1210, 1230, and 1250 to which a plurality of first dummy cells are connected, and second bit lines 1220, 1240, and 1260 to which a plurality of second dummy cells are connected. For example, the first bit lines 1210, 1230, and 1250, and the second bit lines 1220, 1240, and 1260 may be configured as pairs, respectively. In detail, the weights of the neural network may include both positive weights and negative weights. Here, the first bit lines 1210, 1230, and 1250 may store the positive weights of the neural network, and the second bit lines 1220, 1240, and 1260 may store the negative weights of the neural network.

In detail, for example, for a first pair (pair 1) of the first bit lines 1210, 1230, and 1250, and the second bit lines 1220, 1240, and 1260, when a certain positive weight (e.g., $W_1$) is stored in an arbitrary memory cell of the first bit line 1210, a weight of 0 may be stored in a memory cell of the second bit line 1220 on the same word line 1211. Similarly, when a certain negative weight (e.g., $-W_2$) is stored in an arbitrary memory cell of the second bit line 1220, a weight of 0 may be stored in a memory cell of the first bit line 1210 on the same word line 1212.

In an embodiment, dummy conductances of a plurality of dummy cells may be determined such that the sum (hereinafter, referred to as $C_{sum1}$) of effective conductances of a plurality of memory cells connected to the first bit lines 1210, 1230, and 1250, and dummy conductance of a plurality of dummy cells connected to the first bit lines 1210, 1230, and 1250 is equal to the sum (hereinafter, referred to as $C_{sum2}$) of effective conductances of a plurality of memory cells connected to the second bit lines 1220, 1240, and 1260, and dummy conductances of a plurality of dummy cells connected to the second bit lines 1220, 1240, and 1260. That is, the plurality of dummy cells may be added to the cell array to compensate for differences between computational results of the neural network device and expected values, and the dummy conductances may be determined such that the sum $C_{sum1}$ of all conductances of the first bit line 1210, and the sum $C_{sum2}$ of all conductances of the second bit line 1220, wherein the first bit line 1210 and the second bit line 1220 are configured as a pair. Accordingly, the value of the denominator of Equation 2 for the first bit line 1210, and the value of the denominator of Equation 2 for the second bit line 1220 may be equal to each other. Here, the denominator of Equation 2 may be treated as a constant.

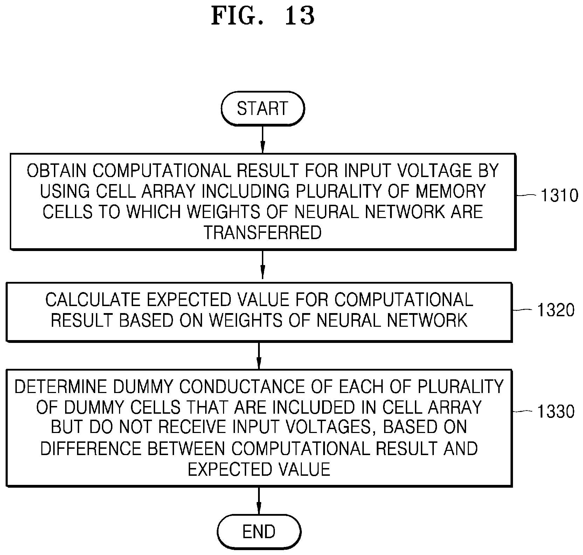

FIG. 13 is a flowchart of a method of implementing a neural network device, according to an embodiment of the present disclosure.

Referring to FIG. 13, in operation 1310, a device for implementing a neural network device (hereinafter, referred to as a 'device') may obtain a computational result for an input voltage by using a cell array including a plurality of memory cells to which weights of the neural network are transferred.

In an embodiment, each of a plurality of bit lines of the cell array may be connected to an analog-to-digital converter configured to detect an output voltage corresponding to an input voltage and converts the output voltage into a digital signal.

In operation 1320, the device may calculate an expected value for the computational result based on the weights of the neural network.

In operation 1330, the device may determine a dummy conductance of each of a plurality of dummy cells that are included in the cell array but do not receive input voltages, based on the difference between the computational result and the expected value.

In an embodiment, the description of the neural network device, the cell array, the plurality of word lines and the plurality of bit lines of the cell array, the plurality of memory cells, the plurality of dummy cells, the input voltages, the output voltages, the analog-to-digital converter, etc. may be the same as described above with reference to FIGS. 1 to 12.

FIG. 14 is a block diagram of a device for implementing a neural network device, according to another embodiment of the present disclosure.

Referring to FIG. 14, a device 1400 may include a communication unit 1410, a processor 1420, and a database (DB) 1430. FIG. 14 illustrates the device 1400 including only the components related to an embodiment. Thus, it would be understood by those of skill in the art that other general-purpose components may be further included in addition to those illustrated in FIG. 14.

The communication unit 1410 may include one or more components for performing wired/wireless communication with an external server or an external device. For example, the communication unit 1410 may include at least one of a short-range communication unit (not shown), a mobile communication unit (not shown), and a broadcast receiver (not shown). In an embodiment, the communication unit 1410 may use at least one communication protocol of Serial Peripheral Interface (SPI) and Universal Asynchronous Receiver/Transmitter (UART).

The DB 1430 is hardware for storing various pieces of data processed by the device 1400, and may store a program for the processor 1420 to perform processing and control.

The DB 1430 may include random-access memory (RAM) such as dynamic RAM (DRAM) or static RAM (SRAM), read-only memory (ROM), electrically erasable programmable ROM (EEPROM), a compact disc-ROM (CD-ROM), a Blu-ray or other optical disk storage, a hard disk drive (HDD), a solid-state drive (SSD), or flash memory.

The processor 1420 controls the overall operation of the device 1400. For example, the processor 1420 may execute programs stored in the DB 1430 to control the overall operation of an input unit (not shown), a display (not shown), the communication unit 1410, the DB 1430, and the like. The processor 1420 may executing programs stored in the DB 1430 to control some components of the device 1400. That is, the processor 1420 may control at least some of operations of the components of the device 1400.

For example, the processor 1420 may obtain the result of the operation of the bit line connected to the memory cells (or memory cells and dummy cells) from the analog-to-digital converter ADC, or from a separate external communication module connected to the ADC, by controlling the communication unit 1410 of the device 1400.

Also, for example, the processor 1420 may calculate the expected value of the result of the operation by applying the weights known to be stored in the memory cells of the neural network to the right-hand side of Equation 2 described above. Alternatively, the processor 1420 may calculate the expected value of the result of the operation by applying the weights known to be stored in the memory cells and the dummy cells of the neural network to the right-hand side of Equation 2 described above.

Furthermore, for example, the processor 1420 may determine the dummy conductance that each of the plurality of dummy cells should have, based on the difference between the result of the operation and the expected value, so that the result of the operation approaches the expected value.

The processor 1420 may be implemented by using at least one of application-specific integrated circuits (ASICs), digital signal processors (DSPs), digital signal processing devices (DSPDs), programmable logic devices (PLDs), field-programmable gate arrays (FPGAs), controllers, microcontrollers, microprocessors, and other electrical units for performing functions.

In an embodiment, the device 1400 may be a server. The server may be implemented as a computer device or a plurality of computer devices that provide a command, code, a file, content, a service, and the like by performing communication through a network. For example, the server may determine the value of a dummy conductance.

Meanwhile, embodiments of the present disclosure may be implemented as a computer program that may be executed through various components on a computer, and such a computer program may be recorded in a computer-readable medium. In this case, the medium may include a magnetic medium, such as a hard disk, a floppy disk, or a magnetic tape, an optical recording medium, such as a CD-ROM or a digital video disc (DVD), a magneto-optical medium, such as a floptical disk, and a hardware device specially configured to store and execute program instructions, such as ROM, RAM, or flash memory.

Meanwhile, the computer program may be specially designed and configured for the present disclosure or may be well-known to and usable by those skilled in the art of computer software. Examples of the computer program may include not only machine code, such as code made by a compiler, but also high-level language code that is executable by a computer by using an interpreter or the like.

According to an embodiment, the method according to various embodiments of the present disclosure may be included in a computer program product and provided. The computer program product may be traded as commodities between sellers and buyers. The computer program product may be distributed in the form of a machine-readable storage medium (e.g., a CD-ROM), or may be distributed online (e.g., downloaded or uploaded) through an application store (e.g., Play StoreTM) or directly between two user devices. In a case of online distribution, at least a portion of the computer program product may be temporarily stored in a machine-readable storage medium such as a manufacturer's server, an application store's server, or a memory of a relay server.

The operations of the methods according to the present disclosure may be performed in any suitable order unless otherwise indicated herein or otherwise clearly contradicted by context. The present disclosure is not limited to the described order of the operations. The use of any and all examples, or exemplary language provided herein, is intended merely to better illuminate the present disclosure and does not pose a limitation on the scope of the present disclosure unless otherwise claimed. Also, numerous modifications and adaptations will be readily apparent to those skilled in the art without departing from the spirit and scope of the present disclosure.

Accordingly, the spirit of the present disclosure should not be limited to the above-described embodiments, and all modifications and variations which may be derived from the meanings, scopes and equivalents of the claims should be construed as failing within the scope of the present disclosure.

According to an embodiment of the present disclosure, an issue of voltage drop due to a high output current flowing in a bit line may be resolved.

In addition, according to an embodiment of the present disclosure, by compensating for an error between weights of a neural network and physical hardware, accurate computation may be performed.

The effects of the embodiments are not limited to the foregoing, and other effects that are not mentioned herein may be clearly understood by those of skill in the art from the description of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A neural network device comprising:

   a digital-to-analog converter configured to convert a digital signal into input voltages;
   a cell array comprising a plurality of memory cells that are arranged in a plurality of bit lines and a plurality of word lines and has weights of a neural network transferred thereto, wherein the cell array is configured to output, through the plurality of bit lines, output voltages obtained by performing computation on the input voltages that are input through the plurality of word lines; and
   an analog-to-digital converter configured to detect the output voltages and convert the output voltages into a digital signal.

2. The neural network device of claim 1, wherein the output voltages of the plurality of bit lines are weighted averages of the input voltages that are input through the plurality of word lines, wherein the weighted averages are calculated by using, as weights, conductances of memory cells that are connected to the plurality of bit lines and correspond to the input voltages, respectively.

3. The neural network device of claim 1, wherein the cell array comprises a plurality of dummy cells connected to the plurality of bit lines, respectively, and to which the input voltages are not applied.

4. The neural network device of claim 3, wherein the output voltages of the plurality of bit lines are determined based on the input voltages that are input through the plurality of word lines, effective conductances of the plurality of memory cells connected to the plurality of bit lines, and dummy conductances of the plurality of dummy cells connected to the plurality of bit lines.

5. The neural network device of claim 4, wherein the dummy conductances are determined based on a difference between a result value of performing computation on the input voltages based on the effective conductances, and an expected value based on the weights of the neural network.

6. The neural network device of claim 4, wherein the plurality of bit lines comprise a first bit line to which a plurality of first dummy cells are connected, and a second bit line to which a plurality of second dummy cells are connected, and

the dummy conductances of the plurality of dummy cells are determined such that a sum of the effective conductances of the plurality of memory cells connected to the first bit line and the dummy conductances of the plurality of first dummy cells is equal to a sum of the effective conductances of the plurality of memory cells connected to the second bit line and the dummy conductances of the plurality of second dummy cells.

7. The neural network device of claim 6, wherein the first bit line and the second bit line are configured as a pair,

the first bit line stores positive weights of the neural network, and
the second bit line stores negative weights of the neural network.

8. The neural network device of claim 4, wherein the output voltages of the plurality of bit lines are weighted averages of the input voltages that are input through the plurality of word lines, wherein the weighted averages are calculated by using, as weights, effective conductances of memory cells that are connected to the plurality of bit lines and correspond to the input voltages, respectively.

9. A method of implementing a neural network device, the method comprising:

obtaining a computational result for input voltages by using a cell array comprising a plurality of memory cells to which weights of a neural network are transferred;
calculating an expected value for the computational result based on the weights of the neural network; and
determining a dummy conductance of each of a plurality of dummy cells that are included in the cell array but do not receive the input voltages, based on a difference between the computational result and the expected value,
wherein each of a plurality of bit lines of the cell array is connected to an analog-to-digital converter configured to detect output voltages corresponding to the input voltages, and convert the output voltages into a digital signal.

10. A computer-readable recording medium recording thereon a program for causing a computer to execute the method of claim 9.

FIG. 1

# FIG. 2

# FIG. 3

PROCESSING UNIT

CONTROL UNIT

LOGIC UNIT

DATA

CONVENTIONAL MEMORY

COMPUTING FUNCTION

# FIG. 4

# FIG. 5A

FIG. 5B

# FIG. 6A

$$Y_k = \sum_{i=1}^{n} W_{ik} * X_i$$

$$
\begin{bmatrix} X_1 \\ X_2 \\ \vdots \\ X_n \end{bmatrix}^T
\begin{bmatrix} W_{11} & W_{12} & \cdots & W_{1m} \\ W_{21} & W_{22} & \cdots & W_{2m} \\ \vdots & \vdots & \ddots & \vdots \\ W_{n1} & W_{n2} & \cdots & W_{nm} \end{bmatrix}
$$

610    611

$$
=
\begin{bmatrix} Y_1 & Y_2 & \cdots & Y_m \end{bmatrix}
$$

612

# FIG. 6B

$$V'_k = \sum_{i=1}^{n} C_{ik} * V_i$$

# FIG. 7

EP 4 700 656 A1

# FIG. 8

# FIG. 9

# FIG. 10

## FIG. 11

# FIG. 12

Pair 1   Pair 2   Pair 3  · · ·

1211

1212

$W_1$   0

0   $-W_2$

0   $-W_3$

$W_4$   0

0   $-W_5$

$W_6$   0

1210   1220   1230   1240   1250   1260

# FIG. 13

START

OBTAIN COMPUTATIONAL RESULT FOR INPUT VOLTAGE BY USING CELL ARRAY INCLUDING PLURALITY OF MEMORY CELLS TO WHICH WEIGHTS OF NEURAL NETWORK ARE TRANSFERRED — 1310

CALCULATE EXPECTED VALUE FOR COMPUTATIONAL RESULT BASED ON WEIGHTS OF NEURAL NETWORK — 1320

DETERMINE DUMMY CONDUCTANCE OF EACH OF PLURALITY OF DUMMY CELLS THAT ARE INCLUDED IN CELL ARRAY BUT DO NOT RECEIVE INPUT VOLTAGES, BASED ON DIFFERENCE BETWEEN COMPUTATIONAL RESULT AND EXPECTED VALUE — 1330

END

# FIG. 14

```
                                    ⌐1400
┌──────────────────────────────────┐
│             DEVICE                │
│                          ⌐1410    │
│   ┌──────────────────────────┐    │
│   │   COMMUNICATION UNIT     │    │
│   └──────────────────────────┘    │
│                          ⌐1420    │
│   ┌──────────────────────────┐    │
│   │        PROCESSOR         │    │
│   └──────────────────────────┘    │
│                          ⌐1430    │
│   ┌──────────────────────────┐    │
│   │           DB             │    │
│   └──────────────────────────┘    │
└──────────────────────────────────┘
```

Europäisches
Patentamt

European
Patent Office

Office européen
des brevets

# EUROPEAN SEARCH REPORT

**Application Number**

EP 25 15 0032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WAN WEIER ET AL: "A compute-in-memory chip based on resistive random-access memory", NATURE, vol. 608, no. 7923, 17 August 2022 (2022-08-17), pages 504-512, XP093237133, London ISSN: 0028-0836, DOI: 10.1038/s41586-022-04992-8 Retrieved from the Internet: URL:https://www.nature.com/articles/s41586-022-04992-8> * page 507 - page 511; figure 3b * ----- | 1-10 | INV. G06N3/065 |
| A | LIM DONG-HYEOK ET AL: "Spontaneous sparse learning for PCM-based memristor neural networks", NATURE COMMUNICATIONS, vol. 12, no. 1, 12 January 2021 (2021-01-12), XP093276999, UK ISSN: 2041-1723, DOI: 10.1038/s41467-020-20519-z Retrieved from the Internet: URL:https://www.nature.com/articles/s41467-020-20519-z.pdf> * "Dual weight mapping strategy" subsection; page 3 - page 3 * ----- -/-- | 1-10 | |

| | |
|---|---|
| | **TECHNICAL FIELDS SEARCHED (IPC)** |
| | G06N |

The present search report has been drawn up for all claims

| Place of search | Date of completion of the search | Examiner |
|---|---|---|
| The Hague | 14 May 2025 | Szymanski, Francois |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................................

& : member of the same patent family, corresponding document

EPO FORM 1503 03.82 (P04C01)

**page 1 of 2**

Europäisches Patentamt

European Patent Office

Office européen des brevets

**EUROPEAN SEARCH REPORT**

Application Number

EP 25 15 0032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | AGARWAL SAPAN ET AL: "Compensating for Parasitic Voltage Drops in Resistive Memory Arrays", 2017 IEEE INTERNATIONAL MEMORY WORKSHOP (IMW), IEEE, 14 May 2017 (2017-05-14), pages 1-4, XP033104964, DOI: 10.1109/IMW.2017.7939075 [retrieved on 2017-06-05] * the whole document * ----- | 1-10 | |

TECHNICAL FIELDS
SEARCHED (IPC)

The present search report has been drawn up for all claims

| Place of search | Date of completion of the search | Examiner |
|---|---|---|
| The Hague | 14 May 2025 | Szymanski, Francois |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)